Europäisches Patentamt

European Patent Office

Office européen des brevets

(19)

(11) Publication number: **0 078 608**
**B1**

(12) **EUROPEAN PATENT SPECIFICATION**

(45) Date of publication of patent specification: 02.08.89

(51) Int. Cl.⁴: **H 03 M 1/42**

(21) Application number: **82305186.7**

(22) Date of filing: **30.09.82**

(54) Analog-to-digital converter.

(30) Priority: **03.11.81 US 317713**
**03.11.81 US 317714**
**03.11.81 US 317715**
**03.11.81 US 317716**

(43) Date of publication of application:
**11.05.83 Bulletin 83/19**

(45) Publication of the grant of the patent:
**02.08.89 Bulletin 89/31**

(84) Designated Contracting States:
**DE FR GB NL**

(56) References cited:
**None**

(73) Proprietor: **TEXAS INSTRUMENTS**
**INCORPORATED**
**13500 North Central Expressway**
**Dallas Texas 75265 (US)**

(72) Inventor: **Domogalla, John C.**
**2823 Valley Forest**
**Missouri City Texas 77489 (US)**

(74) Representative: **Abbott, David John et al**
**Abel & Imray Northumberland House**
**303-306 High Holborn**
**London, WC1V 7LH (GB)**

EP 0 078 608 B1

Courier Press, Leamington Spa, England.

## Description

### Background of the invention
### Field of invention

This invention relates to data acquisition for digital systems and more specifically to analog to digital data conversion.

### Description of prior art

Of all interfaces between different types of systems, the most important and most difficult is usually a link between the analog and digital sections of the system. The interface between the digital circuitry and analog circuitry includes a digital-analog converter or D/A converter. Likewise the interface between the analog circuitry and the digital circuitry includes an A/D converter. An ideal A/D converter would change an analog signal into a digital signal without delay and without error. Of course, such ideal converters are not available. However A/D converters with some delay and limited accuracy are available and are priced according to their accuracy and speed. The techniques used for A/D and D/A conversions are many. One paper that includes a thorough description of many A/D and D/A conversion techniques is an article by Bernard Gordon and the *IEEE Transactions on Circuit and Systems* Volume CAS-25, No. 7, July 1978, entitled "Linear Electronics Analog/Digital Conversion Architectures, Their Origin Perimeters, Limitations and Application." An additional paper in the same publication also describes MOS analog to digital devices. This paper is entitled "ALL-MOS Analog-Digital Conversion Techniques" by Paul R. Gray and David G. Hodges in the IEEE Transactions on Circuits and Systems, Volume CAS-25, 7 July 1978. This paper specifically describes the technique that is used in this invention under the heading of integrated circuit successive approximation converters. This technique includes charge redistribution which is described in Paul R. Gray's previous paper entitled "All-MOS Charges Redistribution Analog to Digital Conversion Techniques Part I" by James L. McCleary and Paul R. Gray, published in the *IEEE Journal of Solid State Circuits*, Volume SC-10, 6 December 1975 in which charge redistribution is discussed using a bank of weighted capacitors. Problems arise with the use of weighted capacitors in that the fabrication accuracy does not insure the accuracy needed for application. In the past, capacitors have been trimmed in an attempt to adjust them to obtain satisfactory accuracy. One technique that includes resistors and capacitors to obtain a higher resolution disclosed in the paper, "An INMOS 12$_b$ Monotonic 25 microsecond A/D converter by Gahram Fotouhi and David A. Hodges presented at the *1979 IEEE International Solid States Circuits Conference*, page 186. The technique disclosed shows the use of a resistor bank to effectively adjust the charge on capacitors. Another error correcting technique is disclosed in a paper entitled "An Error Correcting 14 Bit-20 Microsecond CMOS A/D Converter" by Aiya G. Boyacigiller, Bazel Weir and Peter D. Bradshaw. Presented at the 1981 IEEE International Solid State Circuits Conference. This technique includes an error correcting circuitry that uses a redundant D/A with a successive approximation register.

In the paper "An Integrated Single-Chip PCM Voice Codec with Filters" by R. Gregorian et al., IEEE Journal of Solid State Circuits, Vol. SC-16, No. 4, August 1981, pp. 322—332, there is described an encoder including an analogue-to-binary-weighted capacitor array, which array defines decision levels at the end points of segments, sixteen equally spaced levels within each segment being defined by a chain of equal-valued resistors.
resistors.

### Summary of the invention

In accordance with the present invention there is provided an analog to digital converter comprising: analog input means (VIN) for receiving an analog signal for conversion to a digital signal; reference terminal means for providing one of a first and a second reference signal (VRH, VRL) as a reference input signal to the analog to digital converter; comparator means having first and second comparator inputs for comparing signals on the first comparator input to signals on the second comparator input and for producing an output signal upon detection of a voltage difference between said first and second comparator inputs; a plurality of binary weighted capacitors forming a capacitor array, each of said plurality of capacitors in said capacitor array having first and second sides, said plurality of capacitors being connected in an array arrangement with the first sides connected together and to the first comparator input for redistribution of charge representative of the analog signal; sampling switch means operably connected to said analog input means for obtaining samples of the analog signal; and switch control means for controlling the operation of said sampling switch means to enable a digital representation of the samples of the analog signal to be provided; characterized in that said sampling switch means comprises first switch means for selectively connecting and disconnecting said first or said second reference signal on said reference terminal means to the second comparator input; second switch means for selectively connecting and disconnecting the same reference signal (VRH or VRL) on said reference terminal means to the first side of the capacitor array; a connection capacitance means for scaling the first switch means to the second switch means and the capacitor array; and third switch means for selectively connecting and disconnecting each second side of the plurality of capacitors between the first and second reference signals (VRH, VRL) on said reference terminal means and the analog input means (VIN); and in that said switch control means selectively controls said first, second, and third switch means.

Brief description of the drawings

The novel features believed characteristic of this invention are set forth in the appended claims; however, this invention can be best understood by referencing the detailed description of the embodiment together with these drawings.

Figure 1 is a schematic of the analog to digital converter together with its interface to the microcomputer.

Figure 2 is a block diagram of the analog to digital converter interfaced to the microcomputer.

Figure 3 is a layout diagram of an integrated circuit implementation of the invention.

Figure 4 is a layout diagram for an integrated circuit including the microcomputer connected to the A/D converter.

Figure 5 is a logic diagram of the B input port.

Figure 6 is a logic diagram of the B input/output port and control register for the A/D converter.

Figure 7 is a logic diagram of the C input/output port.

Figure 8 is a logic diagram illustrating one of the control registers with decoding logic for the converter 81 in Figure 3.

Figure 9 is a logic diagram of the control register for converter 80 in Figure 3.

Figure 10 is a schematic drawing of the resistor array.

Figure 11 illustrates the error bit correction register.

Figure 12 is the logic diagram of the circuitry to increase the resolution of the error correction circuitry.

Figure 13 is a schematic diagram of the reset circuitry for the comparator.

Figure 14 is a logic diagram that illustrates the register for the capacitor array.

Figure 15 is a logic diagram that illustrates the register for the resistor array.

Figure 16 is a logic diagram illustrating the shift logic that is connected to the capacitor register and resistor register to shift a "1" bit through the registers to execute the charge redistribution and error correction algorithms.

Figure 17 is a schematic diagram of the comparator.

Description of the invention

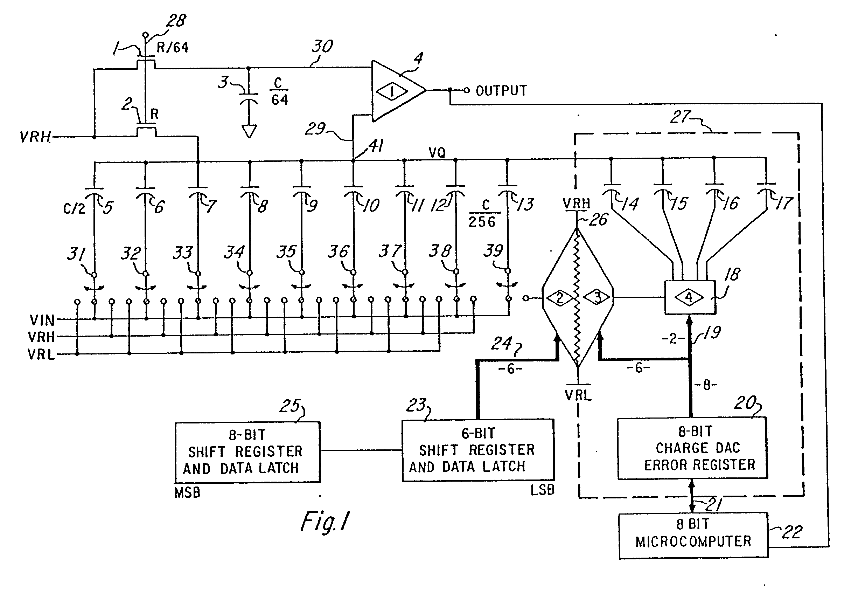

A diagram of the voltage to digital signal converter is illustrated in Figure 1. The inputs to the converter are VIN (voltage input) and VRH and VRL as reference voltages which define the range of the voltage input to be digitally quantized, i.e., if VIN≥VRH, the converter output is hex 3 FFF; if VIN=(VRH−VRL)/2, the converter output is hex 2000; and if VIN≤VRL, the converter output is hex 0000. The converter uses a charge redistribution technique for quantizing the voltage input VIN. This converter includes an array of eight capacitors 5 through 12 and a resistor array 26 connected to a second least significant bit capacitor 13 (i.e., a capacitor that is equal in capacitance to the least significant bit capacitance of capacitor array. The resistor array capacitor combination permits an additional six bits of resolution, eight bits of resolution provided by the capacitor array. For a tutorial discussion of the redistribution technique, the reader is directed to "ALL-MOS Analog-Digital Conversion Techniques" by Paul R. Gray and David A. Hodges, published in the IEEE Transactions on Circuits and Systems, Vol. CAS-25, No. 7, July 1978 and "ALL-MOS Charge Redistribution Analog-to-Digital Conversion Techniques-Part I" by James L. McCreary and Paul R. Gray published in the IEEE Journal of Solid-State Circuits, Vol. SC-10, No. 6, December 1975. The circuitry in Figure 1 includes error circuitry 27 which in combination with an 8 bit microcomputer 22 connected via lines 21 provides for correction of the capacitor stored charge in the capacitor array, i.e., provides that the weights of the capacitors (or capacitor values) are exactly binary fractions. In other words, according to the redistribution technique, if the total capacitance of the array is $C_T$ then capacitor 5 is a value $C_T/2$, capacitor 6 is a value $C_T/4$, capacitor 7 is a value $C_T/8$ and so forth. The circuitry 27 and microcomputer 22 connected to comparator's 4 output provides the capability to determine the weight error of each capacitor in the array and the value of correction required to correct each capacitor's weight.

To accomplish the correction, each capacitor transition is weighted one at a time. First, the line VQ is set to VRH by turning on MOSFET switch devices 1 and 2 accomplished by applying a voltage to line 28. Switches 1 and 2 are then closed allowing line VQ to float (effectively set at VRH). Capacitor 12 is then set to "1", i.e. switch 38 for capacitor 12 is set to VRH. Meanwhile, switches 31 through 37 are set to VRL. Switch 39 is set to VRL. VQ is then reset to VRH via switch 2 as before. Capacitor 12 is set to VRL and capacitor 13 is set to VRH via switches 38 and 39, respectively. If the capacitors were equal in size as they are supposed to be, the point VQ would not change from VRH. However, any deviation of VQ from VRH will be evident from the output of the comparator 4 which is comparing VQ via line 29 to VRH via line 30.

Note that the error correction circuitry is initialized at this point to a zero correction factor to allow for the full voltage difference caused by the error in capacitor 12 to be present on line VQ. The error correction hardware 27 under control of the microcomputer 22 implements a binary search algorithm which provides voltage changes to VQ by charging capacitors 14 through 17 from the resistor array 26 and error circuit decoding hardware 18. This is accomplished by having the microcomputer load an 8 bit word into the error register 20. The most significant six bits are tapped onto the resistor array 26 and provide charge to VQ via capacitor 13 through switch 39. The least significant two bits are decoded by the error decoding hardware 18 to provide charge on the capacitors 14 through 17. When the correct charge is added (or subtracted) from VQ the output of comparator 4 is nulled or zero. The resulting error word is stored as the correction factor for that specific capacitor. After capacitor 12 has been corrected, capacitor 11 is corrected using both capacitor 12 and 13. Capacitors 12 and 13 in parallel sum to the supposed value of capacitor 11. The correction factor for capacitor 12 is used. Capacitor 11 is set to VRH and capacitors 12 and 13 are set to VRL. Then VQ is reset to VRH as before. The error register 20 is reset to zero since the charge correction has already been stored for capacitors 12 and 13. Capacitors 12 and 13 are then set to VRH and capacitor 11 is set to VRL. The difference of VQ from VRH is the error which is nulled by the microcomputer 22 using the binary search algorithm, error correction factors for all eight capacitors in the array. This completes error acquisition phase.

Two sources of error exist in the present configuration as shown. This error correction factor only accounts for one source, i.e. the individual capacitor weighting error. Another source of error results from the voltage change of node 41 during the conversion sequence. Both sources are accounted for by computing the error conversion correction factor which is:

$$C_t/2^i - Ce_i$$

where

$C_t$=is the total of all error correction factors

$i$=is the power of weight for the individual capacitor (where MSB=1, MSB+1=2; "LSB=8)

$Ce_i$=is the individual error correction factor for that capacitor.

The error conversion correction factor is computed in the microcomputer 22.

The converter is now ready to digitize an analog input voltage supplied on line VIN. There are three stages in conversion: sample, setup and redistribution. During the sample stage VQ is set to VRH as previously discussed. All bottom plates of capacitors 5 through 13 are connected to VIN via switches 31 through 39, respectively. During the setup stage the comparator 4 is cleared, switches 1 and 2 are sequenced off and then all capacitors 5 through 13 are switched to VRH. The voltage of node 41 during this initialization is VRH+VRH−VIN. During the redistribution stage, the error value for capacitor 5 will be loaded into the error register 20 and the capacitor switch 31 will connect the capacitor 5 to VRL. The decision is made by the comparator as whether voltage at node 41 is less than the reference (if so, bit=1) or greater or equal to the references (if so, bit=∅). If the bit is 1, then the capacitor remains connected to VRL; if not, then the capacitor is re-connected to VRH as prescribed by the redistribution technique. If the capacitor 5 is connected to VRH, then the error conversion correction factor is removed from the error register. If the capacitor 5 is connected to VRL, then its error conversion correction factor is summed with the error conversion correction factor for the next capacitor 6 and placed in the error register 20. The same process as before is repeated as prescribed by the charge redistribution technique. Note that since capacitor bit values equal to 1 will have their respective error conversion correction factors removed from the error register 20, at the end of the charge redistribution sequence the sum in the error register 20 will be:

$$\Sigma B_i\left(\frac{C_t}{2^i} - Ce_i\right)$$

where,

$B_i$ is the bit value

$C_t$ is the total of error correction factors

$i$ is the individual capacitor weight position (where the MSB=1 and the LSB=8)

$Ce_i$ is the individual capacitor error correction factor.

Also in Figure 1, the size of switch 1 and its connected capacitance 3 are scaled in relation to switch 2 with the capacitor array. This is required as part of the solution to the accuracy problem caused by the voltage dependent capacitive coupling from the gate to the source/drain of MOS Transistor switches. The switch 1 is large since the capacitance of the capacitor array is large and the resistance of switch 1 must be low to allow a fast sample rate.

The charge injected from switches 1, 2 and capacitor array switches is a linear function of the change in gate voltage and a nonlinear function of source/drain potential of those switches. Or more generally, the decoupling voltage is a function of the Reference input and the analog input. Since the analog input is unknown, then its effect must be negated. This is accomplished by the sequential closing of switches. Switch 2 is closed before any of the switches 31 through 39 are closed to allow the charge on the top plates of the capacitor array to be trapped. The decoupling voltage function from the Reference input is effectively negated by the scaling of the Switch 1 and capacitor 3 to switch 2 and the array of capacitors 5 through 13. That is, if the capacitor 3 is 1/64th the capacitance of the array of capacitors 5 through 13, the switch 1 is fabricated to have a gate to drain capacitance of 1/64th that of switch 2. This is accomplished by the selecting the sizes of the two switches. The decoupling voltage is then differentially applied to the comparator 4 and negated through the common made rejection of the comparator.

Note that during both error acquisition/correction phase and the conversion phase that the resistor array 26 and capacitor 13 are used. This is possible since the resistor array 26 has 64 taps dedicated to the conversion phase by connecting via line 24 these taps to the six bit shift register 23 which contains the least significant six bits of the digitized voltage. Resistor array 26 has an additional 64 taps interspaced between the previously mentioned 64 taps. The second set of 64 taps are connected via lines 19 to the error register 10. Two additional bits of error register 20 are connected to the error decoder 18 as previously discussed. This configuration permits the single resistor array 26 to serve two separate functions: error acquisition/correction and conversion.

The difference of this converter architectures from the prior art exists in the capacitor/resistor structure. Previously the resistor array are used to determine the most significant bit positions and the capacitor array was used to determine the least significant bit positions. The advantage of the disclosed architecture is that reduced loading is placed on the resistor array which enhances conversion speed. A disadvantage to the disclosed architecture is the nonmonotonic behavior caused by the weighting errors in the capacitor array. This disadvantage is negated in the disclosed architecture by the error correction sequencing. An additional difference from prior art is that the resistor array 26 is fabricated using polysilicon interconnects rather than an N type diffusion. The use of polysilicon avoids the nonlinear behavior of N type diffusions resulting from voltage dependent conduction.

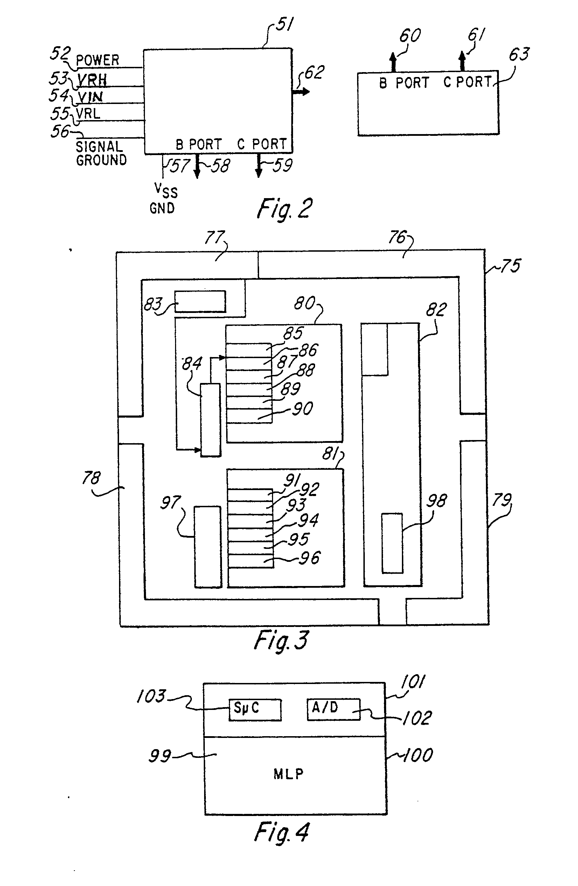

Figure 2 illustrates the converter 51 in block form. The inputs to the converter 51 include a voltage input on line 52, VRH (reference high voltage) on line 53, the VIN (voltage input) on line 54, VRL (reference low voltage) on line 55, signal ground on line 56 and the chip ground on line 57. Lines 58 and 59 are 8 bit parallel input/output ports to be connected to a microcomputer 63 at input/output ports marked 60 and 61, respectively. The interconnection to the microcomputer 63 allows for the data and address transfer between the converter 51 and the microprocessor 63 the output of converter 51 is contained on 14 parallel lines 62. In operation VRH may be set according to the preferred embodiment between 2 and 10 volts. VRL in the preferred embodiment is set between 0 and 5 volts in a manner that does not overlap VRH. The voltage input on line 24 will be digitized between the values of VRL and VRH as previously discussed.

Figure 3 illustrates a chip layout for a test embodiment of the converter 51. The B port is located on chip 75 at location 77 and the C port is located at 76. The B port acts as memory control for the memory contained in the off-chip microcomputer. The C port acts as a multiplexed address data port for the memory address and memory data from the off-chip microprocessor. Area 78 represents the 14 line output of the converter and area 79 represents the analog interface which includes the grounds and the voltage inputs VRH VRL as previously discussed. This test structure actually contains 3 separate converters 80, 81 and 82.

Converter 80 contains metal REOX moat capacitors wherein the capacitors include grown phosphorus oxide. Converter 81 is a converter whose polysilicon gate oxides include a high dose implant channel. Both converters 80 and 81 also include Resistor arrays. Converter 82 is a polysilicon Resistor array converter. A separation of the three converters 80, 81 and 82 on chip 75 is for the purpose of testing. In the fabrication of an A/D converter a preferred embodiment would be to include either a metal converter or the polysilicon converter on a single-chip and connected as outlined in Figure 1. The metal converter 80 and polysilicon converter 81 each contain 8 individual registers. The first 2 registers 85 and 86 are control registers and serve to control the operation of the individual converter. The corresponding registers on the polysilicon converter 81 are registers 91 and 92.

The second two registers 87 and 88 are data registers which correspond to resistors 25 and 23 in Figure 1. The corresponding registers in the polysilicon converter 81 are registers 93 and 94. Register 89 in the metal converter 80 is a temporary register for temporary storage of data from the microcomputer. A corresponding register in the polysilicon converter 81 is register 95. The last remaining register in the metal converter 80 is register 90 which corresponds to the error register 20 in Figure 1. The error register in the polysilicon converter 81 is register 96. The polysilicon resistor converter 82 contains one register 98 which corresponds to register 23 in Figure 1. All of these registers are adjustable by the microcomputer through the C port 76 under control of the B port 77. An ALATCH signal from the microcomputer through the B port 77 together with an address is transmitted to decoders 84 for the metal converter 80 or decoder 97 or the polysilicon converter 81. The ALATCH specifies whether the information from the C port 76 is address information or data information. When the address is transmitted from the C port, it is decoded in either the decoders 84 or 97 to select one of the six registers in either the metal converter 80 or the polysilicon converter 81. Once selected, this register may be written into or read from the microcomputer through the C port. An additional register 83 is included which serves as the select register to determine which of the three converters 80, 81 and 82 will be selected for a test operation. A polysilicon converter 82 includes a register 98 which is also addressed from the microcomputer through the C port.

Figure 4 illustrates preferred embodiment for a semiconductor chip architecture employing the disclosed converter.

Figure 4 shows a chip 101 with a microprocessor portion 99 connected to an analog/digital converter 102 which in turn is connected to a small microcomputer 103. The small microcomputer 103 is an abbreviated version of the microcomputer 99 in that microcomputer 103 merely has a small amount of memory or registers, a small amount of ROM to control the error correction and conversion sequencing together with an ALU for the arithmetic operations. In this configuration the chip 101 would route analog voltage inputs to the analog/digital converter 102 to provide input data to the microprocessor 99 which in turn would provide a digital output.

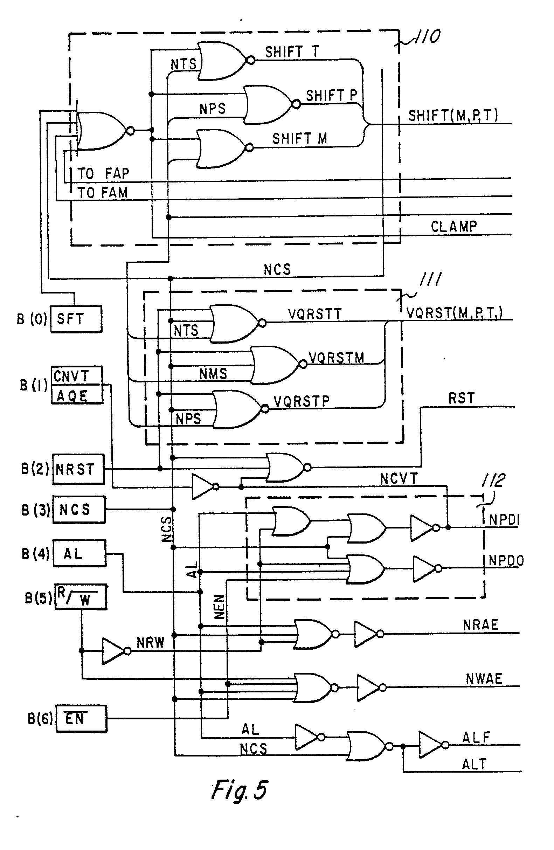

Figure 5 illustrates the B port interface to the chip 75 illustrated in Figure 3. The B port corresponds to the B port of the microprocessor. The B port contains 7 pads marked SFT, CNVT/AQE, NRST, NCS, AL, R/W, EN-. The SFT pad obtains the shift command from the microprocessor the CNVT/AQE specifies whether the device being tested is in the conversion mode, i.e. converting the analog input o=voltage to a 14-bit digital word or in the error acquisition mode as previously discussed. The NRST pad is a reset pad which is active low for the device. The NCS pad is the chip select pad which is active low. Chip select causes all the input and output ports on the chip to go to a high impedance state. The AL pad receives the ALATCH signal which specifies whether the information present on the C port is address or data. R/W specifies whether the information access operation by the microcomputer is a read/or a write. The EN-signal is an enable active low signal. The logic in area 110 produces the shift for either the polysilicon converter, the metal converter or the test converter and originates from the shift signal from the microcomputer, the individual select signal for that specific converter and the clamp signal which will be explained later. Note that the NCS line or chip select active low line is input to halt any chip activity when the chip has not been selected. The logic in area 111 produces the VQRST signal which is the reset VQ line signal to reset the VQ line in Figure 1. This reset signal from the microcomputer produces the internal reset together with the conversion signal and chip select signal. The logic in area 112 takes the ALATCH, the chip select signal, the read/write signal to produce a data input signal and data output signal NPDI and NPDO, respectively, which are used as input/output control signals for the C port. The NRAE and NWAE lines serve as read onto bus A enables and write onto bus A enables both active low which allow the A bus in the port to be written onto or read from. Lastly, the ALT and the ALF lies are used as ALATCH true and ALATCH false for the control registers for the converters.

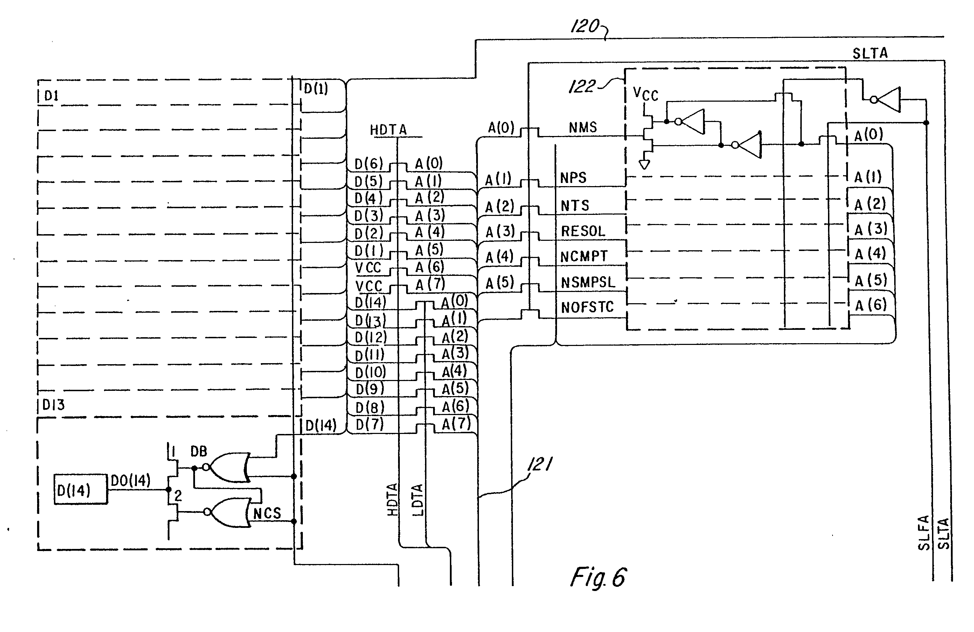

Figure 6 illustrates the D port and the select register. The D port contains 14 bits of which the logic is shown for D14 only. The D port is connected to the D bus 120 which consists of 14 lines.

Note that in D14 that data is loaded onto pad D14 under the control of the chip select active low signal which forces the port into a high impedance condition when the chip is not selected. Also shown is the logic which allows the information on the D bus to be input on the A bus according to the HDTA or High Data to A signal or the LDTA or Low Data to A signal. This allows the data that would be output on the D port to be output through the C port if desired. Also shown is the select register 122 connected to the A bus 121. The select 122 contains 7 bits of information stored in ALATCH shown in the A∅'s bit position. This latch is controlled by two signals SLFA, which is select from A, or SLTA, which is select to A, to read and write into the select register 122.

Note that the bit positions have specific output names on the select register 122. NMS is the metal converter select signal active low. NPS is the polysilicon converter select active low. NTS is the test converter select active low. RESOL is the resolution bit. NCMPT is the conversion bit signal active low. NSMPSL is the sample select signal active low bit. NOFSTC is the offset select signal active low. These control signals select conditional hardware in the comparator circuit for tests.

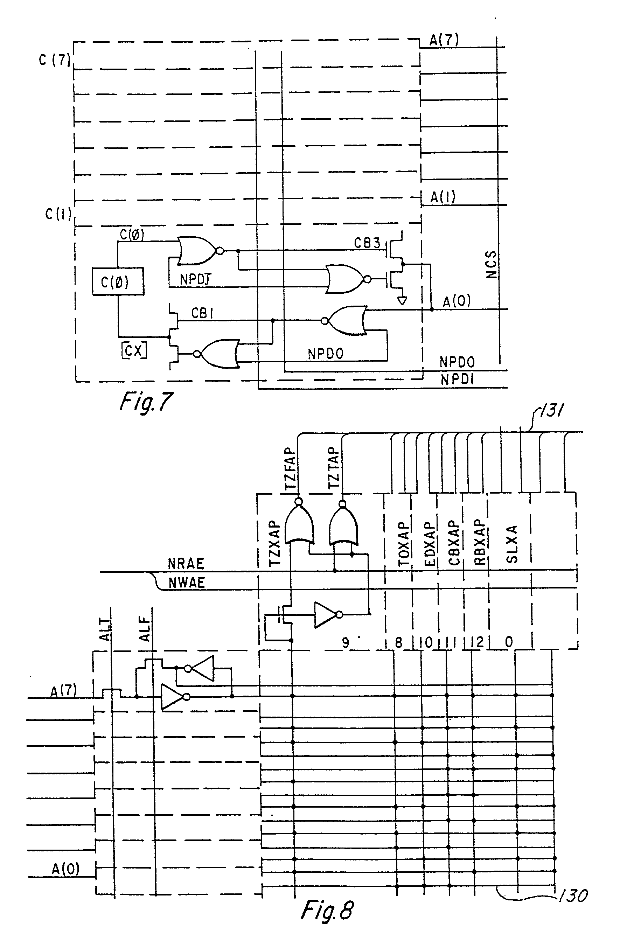

Figure 7 illustrates the C port which is an 8 bit input/output port connected to the microcomputer. Each of the 8 bit positions are identical to the bit position illustrated as C∅ which contains an input and output pad controlled by logic connected to NPDO and NPDI which is the port data input and port data outputs, respectively.

Figure 8 illustrates the code logic for the polysilicon converter. Note that this decoding logic includes an address latch containing 8 bits A∅ to A7. These lines are connected to the A bus and allow for the latching of the address off the A bus under the control of the ALATCH signals in the form of ALT, ALATCH true, and ALAF, ALATCH false. The address signal is then decoded in the program logic array 130 into signals TZXAP, TOXAP, EDXAP, CBXAP, RBXAP, SLXA, and RDAC. Note that each individual signal has dual outputs which represent the true and the false states of the signal. For example, TZXAP stands for the temporary 0 Register for the A bus for the polysilicon converter. This in turn results in two signals which are temporary TZFAP and TZTAP which are temporary 0 Register from the A bus for the polysilicon converter and temporary 0 register to the A bus from the polysilicon converter. This Allows for inputting and outputting of data to the temporary 0 register as will be discussed. TOXAP is a similar type function for the temporary 1 register which will also be discussed. Like the temporary 0 Register lines previously discussed, the TOXAP portion of the circuit results in two lines of TOFAP and TOTAP. EDXAP controls the input and the output of the error digital/analog converter (DAC) register. CBXAP controls the input to the capacitor bit register. RBXAP controls the input and output of the Resistor bit register. SLXA controls the input and output of the select register as previously discussed. RDAC controls the input and output to the test converter.

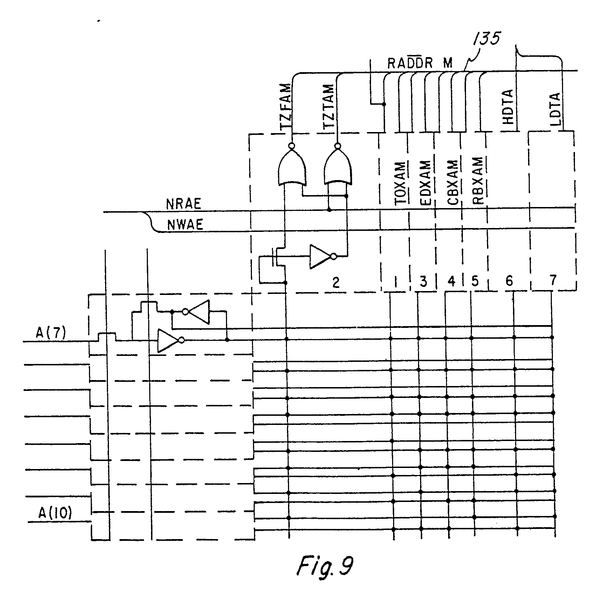

Figure 9 illustrates the address latch and address decode circuitry for the metal converter, note that this circuitry is identical to the circuitry in Figure 8 of the polysilicon converter. The output signals on bus 135 are the same for the temporary 0 register, the temporary 1 register, the error DAC register, the capacitor bit register and the resistor bit register.

However, other signals that result are HDTA and LDTA which control the loading of the D bus onto the A bus so that the data may be output through the C port. HDA as previously discussed stands for High Data to A bus and LDTA stands for Low Data to A.

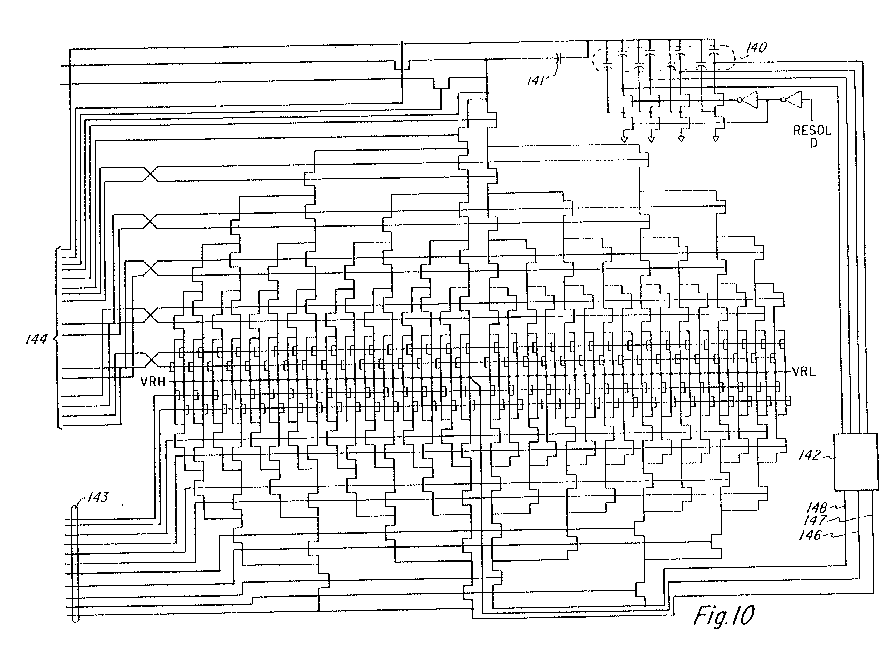

Figure 10 illustrates the resistor array which is identical for either the polysilicon converter or the metal converter. This array 145 serves a dual purpose for error correction and for conversion as previously discussed. Note that for conversion the input is received from lines marked as 144 which provide for the taps to the resistor array which is in turn connected to the capacitor 141. Capacitor 141 corresponds to the capacitor 13 in Figure 1. The error correction side receives 6 bits of input from lines 143. Note that the error correction is bipolar and line 146 acts as the neutral line in order to allow charge to be added or subtracted from the VQ line in Figure 1. The tap outputs of the resistor array 145 for error acquisition are connected to the error correction logic 142 which is in turn connected to the capacitor bank 140. The capacitor bank 140 in Figure 10 corresponds to capacitors 14, 15, 16 and 17 in Figure 1. The existence of these capacitors 140 is to increase the resolution of error correction. The 6 bits 143 control 6 bits of the error word as previously discussed and control the charge through capacitor 141. The remaining 2 bits in the error register control the error logic 142 as will be discussed. The capacitor array itself consists of a polysilicon resistor 5 microns long fabricated in a winding fashion with 64 taps on one side of the winding resistor and 64 taps on the other side. One set of 64 taps is dedicated to the resolution register and the other set of bH taps is connected to the error correction Register as previously discussed.

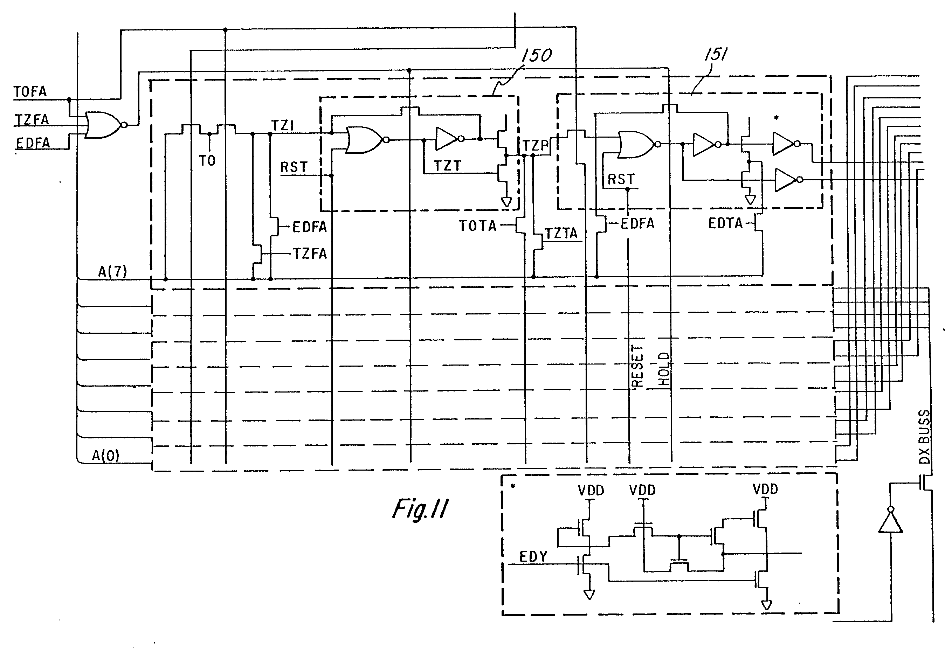

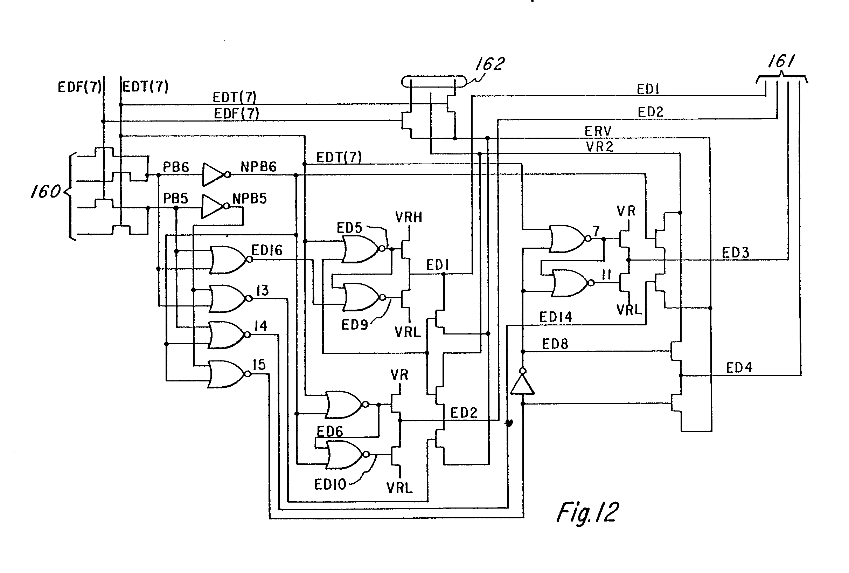

Figure 11 illustrates the 8 bit error correction register shown as block 20 in Figure 1. Note that in Figure 11 the 8 bit register is divided into 8 portions but only the circuitry for the 7th or most significant bit is shown. The circuitry for the remaining portions of the error bit register are identical. The error register is divided into three parts. The first part marked by T0 is the temporary 1 register. The second part marked as 151 is the latch for the temporary 0 register. The third portion is labelled 151 is the error digital to analog conversion register. The temporary 0 register and error digital to analog register are latches of the circuitry. The temporary 1 register is merely a switch which acts as a pseudo register by allowing the data on the A bus to be loaded. Referring back to the discussion of error correction, the error conversion correction factor is computed by the factors for the individual registers into the error register 20 as shown in Figure 1, which have a bit output of 0 according to the charge redistribution technique. If the bit value of the capacitor according to the comparator output is a 1, however, the error correction factor must be removed from the error register in order to compute the total error conversion correction factor for the capacitor array as previously discussed. If the bit value is 1 the circuitry shifts the comparison to the next capacitor in the array while the output of the comparator itself is clamped. The data on the A bus then passes through temporary register 1 by means of the bit line and temporary 1 from A (TOFA) line as shown to the error digital to analog register through the temporary 0 register. If, however, the bit value is 0, the data in temporary 0 register is copied into the error digital analog register with no input from the temporary 1 register. The 8 bit output of the error register is divided into 6 bits which are input to the resistor array as previously discussed. The other two bits are connected to the error correction hardware shown as block 18 in Figure 1 but illustrated in more detail in Figure 12.

Figure 12 illustrates that the resolution hardware receives 2 inputs on lines 160 from the error register and outputs voltage on 4 lines 161 to the capacitors illustrated in Figure 10 as capacitors 140. It should be noted that the main purpose of this error resolution hardware in Figure 12 is merely to add 2 additional bits of resolution to the error correction capability. The logic circuitry shown in Figure 12 is merely a reduction of the coding states needed to provide charge to the capacitors 140 in Figure 10.

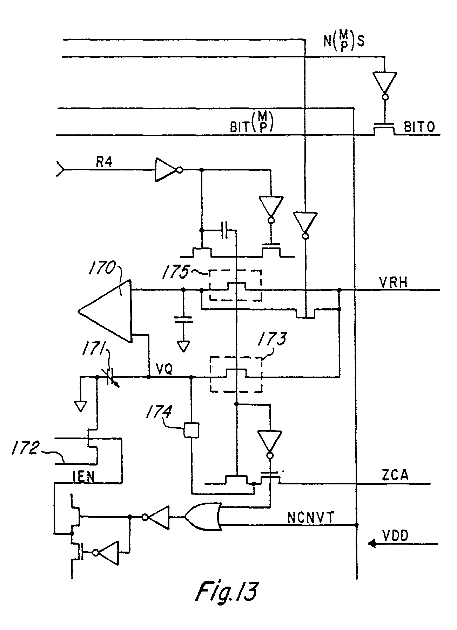

Figure 13 illustrates the reset circuitry for the comparator. The reset signal R4 comes from the comparator 170 that enables switch 1 marked as 173 and switch 2 marked as 175 to close before the enable line switches off the voltage input via line 172. This is accomplished by the delay is sequencing the signals from R4 through switch 2, switch 1 and into circuitry to produce the enable line. It should also be noted that switch 2,175 and capacitor 176 are scaled proportionally to switch 1,173 and the capacitor array 171 as previously discussed. Capacitor 174 connected to VQ is used to adjust the offset voltage by having a voltage to line ZCA (0 correction adjust).

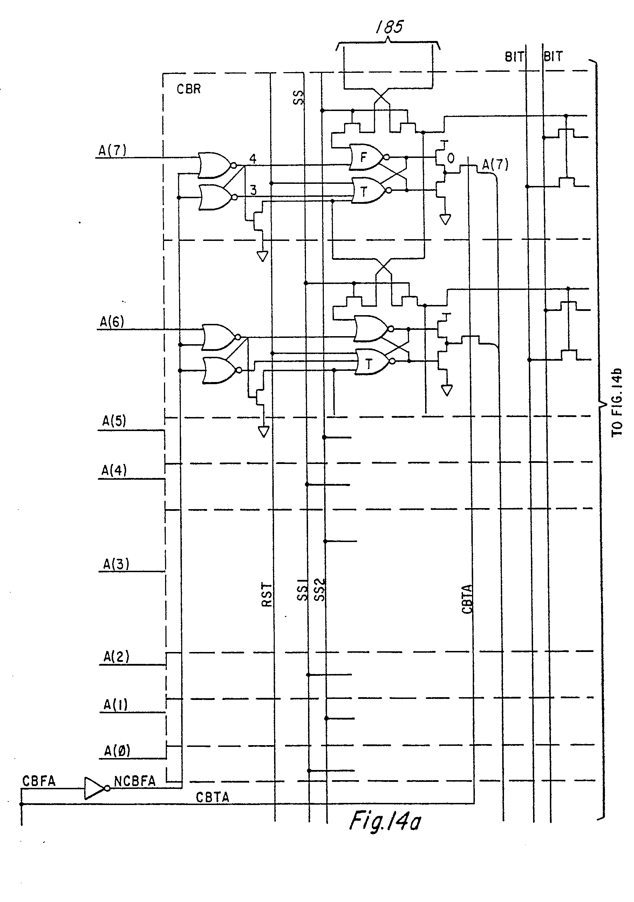

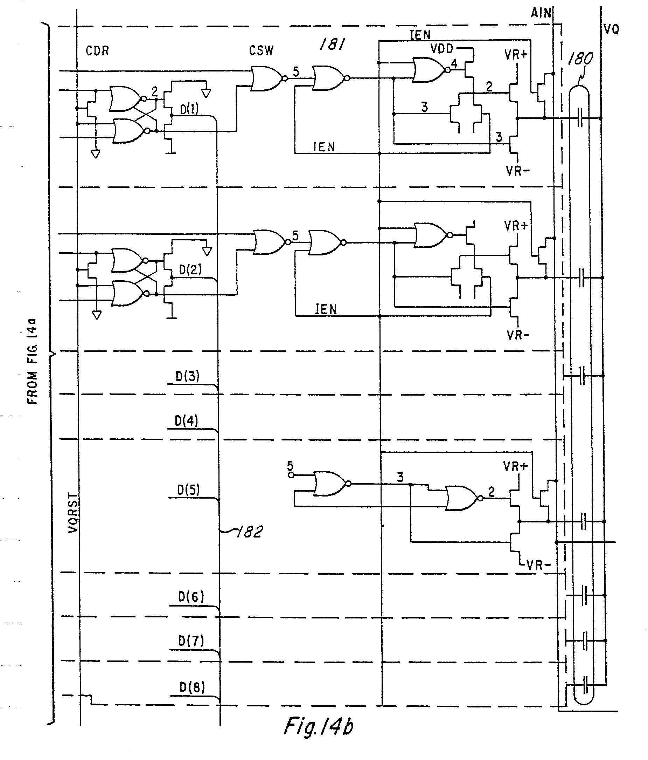

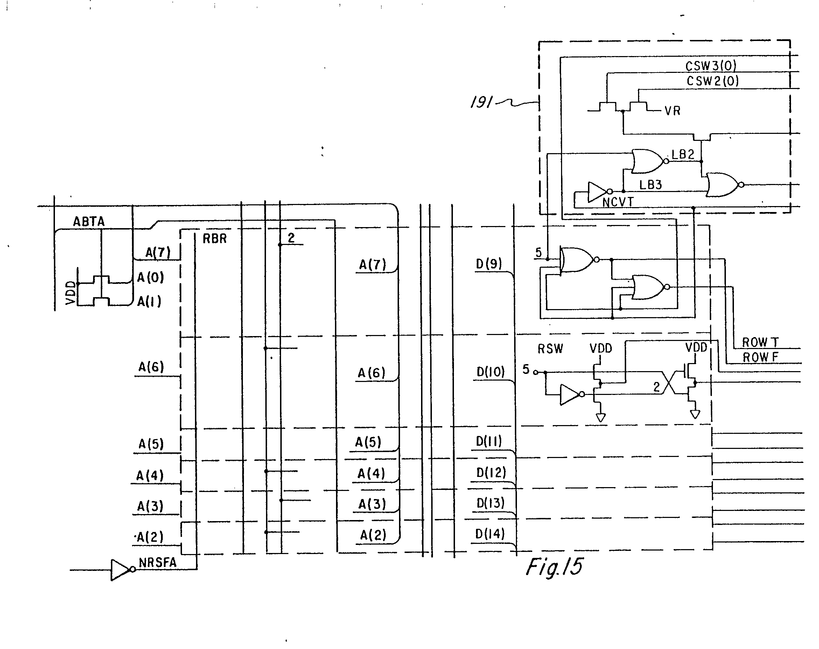

Figure 14 and Figure 15 illustrate the capacitor register and resistor array register, respectively. Referring now to Figure 14, the capacitor register is divided into 3 parts: the capacitor bit register (CBR), the capacitor data register (CDR) and the capacitor switch (CSW). The capacitor bit register is connected to the A bus and acts as a storage latch to store specific bit data during error acquisition and also during conversion to maintain the single one that rolls through the 8 bit position of the capacitor register in order to perform the charge distribution procedure. Note when reset falls, the one that is initially alerted into A7 is transferred into A6 from either the SS1 line or the SS2 lines which represent a dual phase nonoverlapping clock. In other words, when a 1 is loaded into bit position 7 and SS1 occurs, the 1 will be rolled into bit position 6 and a 0 will be rolled into pit position 7. Then from the occurrence of SS2, the 1 that was in bit position 6 will be rolled into bit position 5 and bit position 6 will maintain a 0 as will all the other bit positions with the exception of bit position 5. This bit register is also connected to the capacitor data register CDR. The capacitor data register also receives the output from the comparator on the BIT or NBIT lines. This output is used by the capacitor switch to either switch the capacitor in or out of the array as prescribed by the charge redistribution procedure. Note that capacitors 180 are the weighted capacitor array connected to the node. It should also be noted that the output of the capacitor data register is connected to the D bus 182 as previously discussed. Figure 15 illustrates the 6 bit register for the resistor array which is similar to the capacitor register in Figure 14. One difference is the circuitry contained in 191 allows the second least significant bit capacitor to be disconnected from the resistor array during error correction.

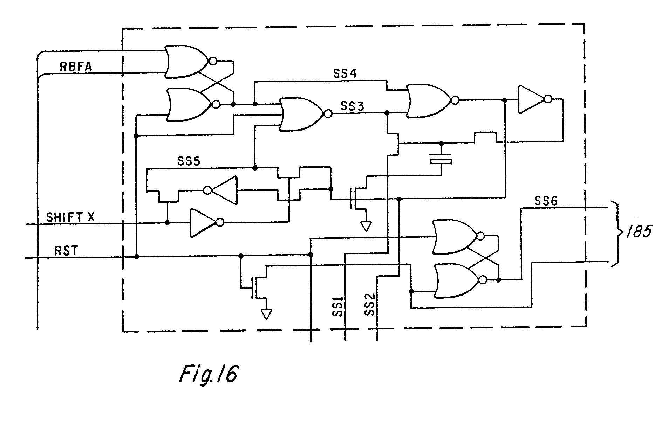

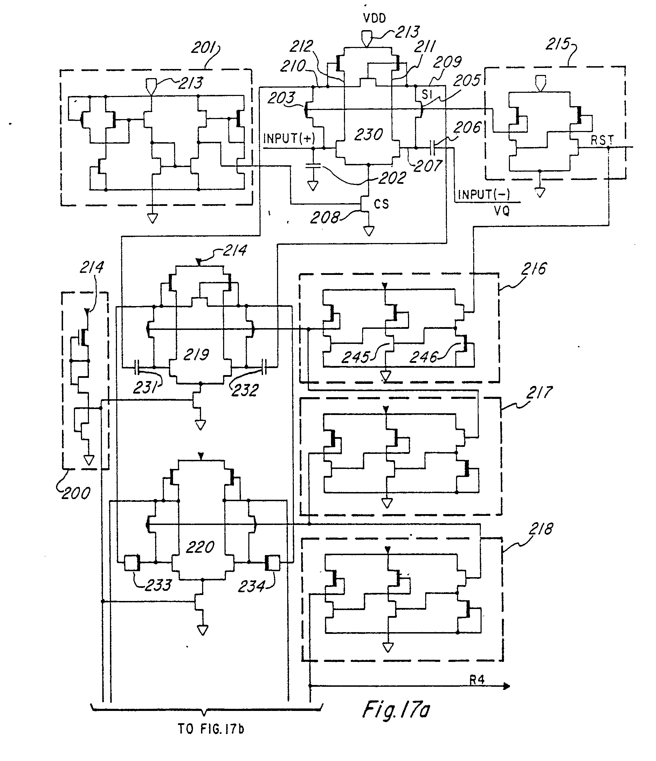

Figure 16 illustrates the shift logic that is connected to the capacitor register 25 in Figure 14 and resistor register 23 in Figure 15. This logic produces the SS1 and SS2 signals as previously discussed which results in the shifting of a 1 through the capacitor register 25 and resistor register 23 in order to perform the charge redistribution procedure.

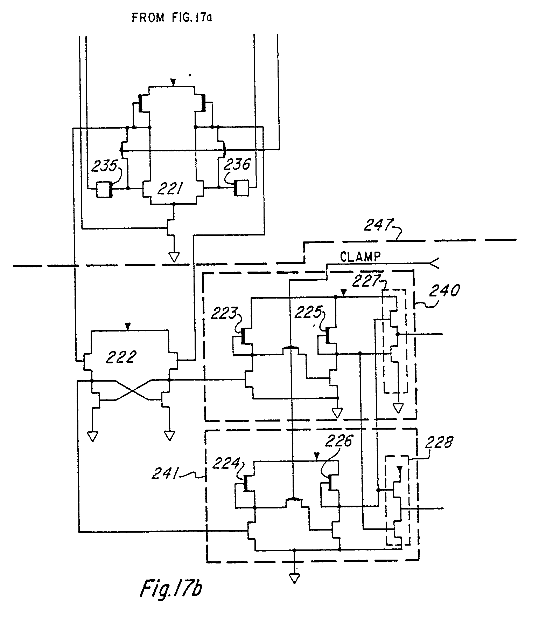

Figure 17 illustrates the comparator 4 as shown in Figure 1. The comparator can be divided into 2 parts, the first above the line 247 is the preamplifier portion, the circuitry below line 247 is the power amplifier. The preamplifier section consists of 4 stages, 230, 219, 220, and 221. Each individual stage is a common source differential amplifier with 2 legs 210 and 211 as shown in stage 230. The structure provides for differential input with the output being a differential voltage gain with common mode rejection. The 2 inputs through to the comparator are placed on lines 204 and 207 through the offset voltage capacitors 202 and 206. The output is placed on lines 209 and 210. Circuitry 215 is provided to receive and isolate the comparator from the reset signal, when the reset signal is received it turns switches 203 and 205 to an on state which effectively clamps the inputs to the outputs for the stage, this allows the signal placed on capacitors 206 and 202 to be transmitted through through the output lines to the next stage which is in turn switched by circuitry 216. This process continues through the circuitry 217 and 218, allowing this signal voltage to be output from the comparator. The capacitors in the stages 230 and 219 are different in fabrication from the capacitors in stages 220 and 221, in that the capacitors 202, 206, 231 and 232 are metal polysilicon capacitors using a multilevel oxide as a dielectric whereas capacitors 233, 234, 235 and 236 are depleted MOSFET devices acting as capacitors.

This offset voltage results from the current mismatch existing between the legs such as 210 and 211. While the scaling of the two switches 1 and 2 as shown in Figure 1 are equivalent, some small offset voltage still remains. By allowing signal to be transmitted through the comparator through capacitors 202, 206, 231, 232, 233, 234, 235 and 236, the input reflected offset then is divided by the gain of all the differential amplifiers.

Note that the circuits 216, 217 and 218 actually act as delay circuits to allow the preceding stage to become operable and transmit its offset voltage to the next stage. Circuits 216, 217 and 218 act as delay circuits according to components 245 and 246 in 216 and the like components in 217 and 218. 245 is an enhanced MOSFET device that acts as a capacitor while device 246 is a depleted MOSFET device which acts as a resistor. This resistor capacitor combination sets the time constant for these time delay circuits and allows for the offset voltage to be loaded across the differential amplifier stages in a sequential manner.

Another feature of the comparator is that it contains circuits for rejection of noise from the power supply. These two power supply biased current circuits are 201 and 202. The first stage is different from the second, third and fourth stages in that the bias circuit 201 and stage itself 230 are tied to Vdd through 213. Vdd can be anywhere from 5 to 15 volts. The Vdd power in circuit 201 is input into the common source device 208. The use of Vdd in the first stage reduces the probability of this first stage being overdriven and thus reducing the probability of the successive stages from being overdriven. In the second, third and fourth stage of the preamplifier section the power supply is Vcc marked as 214. The biased circuit 200 serves the same purpose as the biased circuit 201 except for the second power supply Vcc. Circuitry 222 receives output from the fourth stage of the preamplifier and serves to reduce the bias level of the signal to a digital range for amplification. This cross coupled circuit serves to shift the voltage level of the comparator signal while maintaining its gain. The true and false signal which are output from circuitry 222 is amplified by circuits 240 and 241. The output of 240 is NBIT, the output of 241 is BIT as marked. The circuitry in 240 and 241 are simply two inverter circuits separated by a switch under the control of the CLAMP signal as shown. The CLAMP signal as previously discussed merely turns off the output of the comparator during the reset mode of the converter. After the signal from circuitry 222 is passed to circuitry 240 it passes through two inverters 223 and 225 into a push-pull amplifier 227 for output on the NBIT line. Likewise the circuitry 241 contains the two inverters 224 and 226 and the push-pull circuitry 228. These inverters provide the last stage of amplification for the signals for the comparator.

This comparator is novel in that it allows for the use of power supplies at 5 volts or less. The use of the 5 volt power supply though requires that the noise rejection circuitry as previously discussed be included. Another novel feature of this comparator is that it provides as effective 0 offset voltage by implementation of the previously discussed self-biasing procedure.

## Claims

1. An analog to digital converter comprising: analog input means (VIN) for receiving an analog signal for conversion to a digital signal; reference terminal means (53, 55) for providing one of a first and a second reference signal (VRH, VRL) as a reference input signal to the analog to digital converter; comparator means (4) having first and second comparator inputs (29, 30) for comparing signals on the first comparator input to signals on the second comparator input and for producing an output signal upon detection of a voltage difference between said first and second comparator inputs; a plurality of binary weighted capacitors (5—12) forming a capacitor array, each of said plurality of capacitors in said capacitor array having first and second sides, said plurality of capacitors being connected in an array arrangement with the first sides connected together and to the first comparator input (29) for redistribution of charge representative of the analog signal; sampling switch means operably connected to said analog input means for obtaining samples of the analog signa; and switch control means for controlling the operation of said sampling switch means to enable a digital representation of the samples of the analog signal to be provided; characterized in that

said sampling switch means comprises first switch means (1) for selectively connecting and disconnecting said first or said second reference signal (VRH, VRL) on said reference terminal means (53, 55) to the second comparator input (30);

second switch means (2) for selectively connecting and disconnecting the same reference signal (VRH or VRL) on said reference terminal means (53, 55) to the first side of the capacitor array;

a connected capacitance means (3) for scaling the first switch means to the second switch means and the capacitor array; and

third switch means (31—38) for selectively connecting and disconnecting each second side of the plurality of capacitors between the first and second reference signals (VRH, VRL) on said reference terminal means (53, 55) and the analog input means (VIN);

and in that said switch control means selectively controls said first, second, and third switch means.

2. An analog to digital converter as set forth in Claim 1, further characterized by error correction means (27) for compensating for anomalies in each capacitor of said plurality of capacitors included in said capacitor array, said error correction means including said connected capacitance means (3) as a reference capacitor connected to said second comparator input (30);

supplemental charge circuitry means (14—17) connected in parallel to said capacitor array for adjusting the charge stored in said capacitor array;

error control means (22) for controlling the adjustment of the charge stored in said capacitor array; and

register means (20) for retaining the charge adjustment of each member capacitor of said plurality of capacitors included in said capacitor array.

3. An analog to digital converter as set forth in Claim 2, further characterized in that said supplemental charge circuitry means includes charge circuitry capacitors and switching means to place the charge circuitry capacitors in parallel to the plurality of capacitors included in the capacitor array.

4. An analog to digital converter as set forth in Claim 1 or Claim 2, further characterized by a least significant bit capacitor equivalent means for equivalenting the smallest member capacitors of said plurality of capacitors included in said capacitor array, the least significant bit capacitor equivalent means comprising:

a series connected resistor array (26);

a second plurality of capacitors (14—17) which are binary weighted and connected in an array; and

both the series connected resistor array and the second plurality of capacitors being also in parallel connection with said plurality of capacitors included in said first-mentioned capacitor array.

5. An analog to digital converter as set forth in Claim 4, further characterized in that said resistor array determines the least significant six bits of the analog input signal.

6. An analog to digital converter as set forth in any preceding claim, further characterized in that said capacitor array has eight binary weighted capacitors to measure the eight most significant bits of the analog input signal.

7. An analog to digital converter as set forth in any preceding claim, further characterized in that the said comparator means (4) comprises a plurality of differential amplifiers (230, 219, 220, 221) connected in cascade, each having a pair of differential input terminals (29, 30 for 230) and a pair of differential output terminals (209, 210 for 230), the input terminals of the first of said plurality of differential amplifiers being said first and second comparator inputs, the differential output terminals of each differential amplifier connected to the differential input terminals of the next cascade differential amplifier;

power amplifier means (below line 247) connected to the differential output terminals of the last cascade differential amplifier (221) for separately amplifying the signals at said differential output terminals of said last cascade differential amplifier; and

a plurality of reset isolation means (215, 216, 217, 218), each having a reset input terminal and a reset output terminal, each reset output terminal being connected to a corresponding one of said plurality of differential amplifiers for clamping the voltage at the differential output terminals of said corresponding differential amplifier upon receipt of a signal on said reset input terminal, said plurality of reset isolation means being connected in cascade with the reset input terminal of each reset isolation means being connected to the reset output terminal of the reset isolation means corresponding to the previous differential amplifier for providing a sequentially delayed reset to successive differential amplifiers.

**Patentansprüche**

1. Analog-Digital-Umsetzer mit einem Analogeingangsmittel (VIN) für den Empfang eines in ein digitales Signal umzusetzenden Analogsignals; Referenzanschlußmitteln (53, 55) zur Lieferung eines ersten oder eines zweiten Referenzsignals (VRH, VRL) als Referenzeingangssignal an den Analog-Digital-Umsetzer; einem Komparatormittel (4) mit ersten und zweiten Komparatoreingängen (29, 30) zum Vergleichen von Signalen am ersten Komparatoreingang mit Signalen am zweiten Komparatoreingang und zum Erzeugen eines Ausgangssignals bei der Feststellung einer Spannungsdifferenz zwischen den ersten und zweiten Komparatoreingängen; mehreren binär gewichteten Kondensatoren (5 bis 12), die eine Kondensatormatrix bilden, wobei jeder der mehreren Kondensatoren in der Kondensatormatrix eine erste und eine zweite Seite aufweist und wobei die mehreren Kondensatoren in einer Matrixanordnung mit den ersten Seiten miteinander und mit dem ersten Komparatoreingang (29) zum Verteilen der das Analogsignal repräsentierenden Ladung verbunden sind; Abtastschaltermitteln, die wirkungsmäßig mit dem Analogeingangsmittel verbunden sind, um Abtastwerte des Analogsignals zu erhalten; und Schaltersteuermitteln zum Steuern des Betriebs der Abtastschaltermittel, damit eine digitale Darstellung der Abtastwerte des Analogsignals geliefert werden kann, dadurch gekennzeichnet, daß die Abtastschaltermittel erste Schaltermittel (1) zum selektiven Anlegen oder Abtrennen des ersten oder zweiten Referenzsignals (VRH, VRL) an den Referenzanschlußmitteln (53, 55) an den bzw. von dem zweiten Komparatoreingang (30) enthalten; zweite Schaltermittel (2) zum selektiven Anlegen und Abtrennen des gleichen Referenzsignals (VRH oder VRL) an den Referenzanschlußmitteln (53, 55) an die bzw. von der ersten Seite der Kondensatormatrix enthalten; ein angeschlossenes Kondensatormittel (3) zum Bemessen der ersten Schaltmittel bezüglich der zweiten Schaltmittel und der Kondensatormatrix enthalten; und dritte Schaltmittel (31 bis 38) zum selektiven Anlegen und Abtrennen jeder zweiten Seite der mehreren Kondensatoren zwischen den ersten und zweiten Referenzsignalen (VRH, VRL) an den Referenzanschlußmitteln (53, 55) und dem Analogeingangsmittel (VIN) enthalten; und daß die Schaltersteuermittel in selektiver Weise die ersten, zweiten und dritten Schaltermittel steuern.

2. Analog-Digital-Umsetzer nach Anspruch 1, gekennzeichnet durch Fehlerkorrekturmittel (27) zum Kompensieren von Anomalien in jedem Kondensator der mehreren Kondensatoren in der Kondensatormatrix, wobei die Fehlerkorrekturmittel die angeschlossenen Kondensatormittel (3) als Referenzkondensator enthalten, der an den zweiten Komparatoreingang (30) angeschlossen ist; Zusatzladungs-Schaltungsmittel (14 bis 17), die zum Einstellen der in der Kondensatormatrix gespeicherten Ladung parallel zu der Kondensatormatrix geschaltet sind, Fehlersteuermittel (22) zum Steuern der Einstellung der in der Kondensatormatrix gespeicherten Ladung; und Registermittel (20) zum Festhalten der Ladungseinstellung jedes Teilkondensators der mehreren Kondensatoren in der Speichermatrix.

3. Analog-Digital-Umsetzer nach Anspruch 2, dadurch gekennzeichnet, daß die Zusatzladungs-Schaltungsmittel Ladeschaltungskondensatoren und Schaltmittel zum Parallelschalten der Ladeschaltungskondensatoren zu den mehreren, in der Kondensatormatrix enthaltenen Kondensatoren enthalten.

4. Analog-Digital-Umsetzer nach Anspruch 1 oder Anspruch 2, gekennzeichnet durch ein dem Kondensator für das niedrigstwertige Bit äquivalentes Mittel zur Bildung einer Äquivalenz für die kleinsten Teilkondensatoren der mehreren Kondensatoren in der Kondensatormatrix, wobei das Äquivalenzmittel folgendes enthält: eine in Serie geschaltete Widerstandsmatrix (26); eine zweite Kondensatormenge (14 bis 17), die binär gewichtet sind und in einer Matrix miteinander verbunden sind; und wobei sowohl die in Serie geschaltete Widerstandsmatrix und die zweite Kondensatormenge den in der ersten Kondensatormatrix enthaltenen mehreren Kondensatoren parallelgeschaltet sind.

5. Analog-Digital-Umsetzer nach Anspruch 4, dadurch gekennzeichnet, daß die Widerstandsmatrix die sechs niedrigstwertigen Bits des analogen Eingangssignals bestimmen.

6. Analog-Digital-Umsetzer nach einem der vorhergehenden Ansprüche, dadurch gekennzeichnet, daß die Kondensatormatrix acht binär gewichtete Kondensatoren zum Messen der acht höchstwertigen Bits des analogen Signals entält.

7. Analog-Digital-Umsetzer nach einem der vorhergehenden Ansprüche, dadurch gekennzeichnet, daß die Komparatormittel (4) mehrere Differenzverstärker (230, 219, 220, 221) enthalten, die in Kaskade geschaltet sind und jeweils zwei Differenzeingangsanschlüsse (29, 30 für 230) und zwei Differenzausgangsanschlüsse (209, 210 für 230) enthalten, wobei die Eingangsanschlüsse für die ersten der mehreren Differenzverstärker die ersten und zweiten Komparatoreingänge sind und die Differenzausgangsanschlüsse jedes Differenzverstärkers an die Differenzeingangsanschlüsse des nächsten Differenzverstärkers in der Kaskade angeschlossen sind; daß an die Differenzausgangsanschlüsse des letzten Differenzverstärkers (221) in der Kaskade Leistungsverstärkermittel (unterhalb der Linie 247) angeschlossen sind, mit denen die Signale an den Differenzausgangsanschlüssen des letzten Differenzverstärkers in der Kaskade getrennt verstärkt werden, und daß mehrere Rücksetz-Trennmittel (215, 216, 217, 218) vorgesehen sind, die jeweils einen Rücksetzeingangsanschluß und einen Rücksetzausgangsanschluß aufweisen, wobei jeder Rücksetzausgangsanschluß an einen entsprechenden der mehreren Differenzverstärker angeschlossen ist, damit die Spannung an den Differenzausgangsanschlüssen des entsprechenden Differenzverstärkers nach Empfang eines Signals an dem Rücksetzeingangsanschluß geklemmt wird, wobei die mehreren Rücksetztrennmittel in Kaskade geschaltet sind und der Rücksetzeingangsanschluß jedes Rücksetztrennmittels mit dem Rücksetzausgangsanschluß des Rücksetztrennmittels entsprechend dem vorhergehenden Differenzverstärker verbunden ist, damit aufeinanderfolgenden Differenzverstärkern eine sequentiell verzögerte Rücksetzung zugeführt wird.

**Revendications**

1. Convertisseur analogique-numérique comprenant: des moyens d'entrée analogique (VIN) pour recevoir un signal analogique destiné à être converti en un signal numérique; des moyens formant bornes de référence (53, 55) pour fournir l'un de premier et de second signaux de référence (VRH, VRL) en tant que signal d'entrée de référence au convertisseur analogique-numérique; des moyens formant comparateur (4) ayant des première et seconde entrées de comparaison (29, 30) pour comparer des signaux sur la première entrée du comparateur avec des signaux sur la seconde entrée du comparateur et pour fournir un signal de sortie en réponse à la détection d'une différence de tension entre lesdites première et seconde entrées du comparateur; plusieurs condensateurs (5 à 12) pondérés en binaire formant un réseau de condensateurs, chacun desdits plusieurs condensateurs dans ledit réseau de condensateurs ayant des premier et second côtés, lesdits plusieurs condensateurs étant connectés dans un agencement de réseau avec les premiers côtés connectés ensemble et à la première entrée (29) du comparateur pour redistribuer une charge représentative du signal analogique; des moyens formant commutateur d'échantillonnage connectés auxdits moyens d'entrée analogique pour obtenir des échantillons du signal analogique; et des moyens de commande de commutateur pour commander le fonctionnement desdits moyens formant commutateur d'échantillonnage pour permettre l'obtention d'une représentation numérique desdits échantillons du signal analogique; caractérisé en ce que lesdits moyens formant commutateur d'échantillonnage comprennent des premiers moyens formant commutateur (1) pour connecter et déconnecter de façon sélective lesdits premier et second signaux de référence (VRH, VRL) sur lesdits moyens formant bornes de référence (53, 55) à ladite seconde entrée (30) du comparateur; des seconds moyens formant commutateur (2) pour connecter et déconnecter de façon sélective le même signal de référence (VRH ou VRL) sur lesdits moyens formant bornes de référence (53, 55) au premier côté du réseau de condensateurs; des moyens (3) formant condensateur connecté, pour adapter les premiers moyens formant commutateur aux seconds moyens formant commutateur et au réseau de condensateurs; et des troisièmes moyens formant commutateur (31 à 38) pour connecter et déconnecter de façon sélective chaque seconde côté desdits plusieurs condensateurs entre les premier et second signaux de référence (VRH, VRL) sur lesdits moyens formant bornes de référence (53, 55) et les moyens d'entrée analogique (VIN); et en ce que lesdits moyens de commande de commutateur commandent de façon sélective les premiers, seconds et troisièmes moyens formant commutateur.

2. Convertisseur analogique-numérique selon la revendication 1, caractérisé en outre par des moyens de correction d'erreur (27) pour compenser des anomalies dans chaque condensateur parmi lesdits plusieurs condensateurs dudit réseau de condensateurs, lesdits moyens de correction d'erreur comprenant lesdits moyens (3) formant condensateur connecté, en tant que condensateur de référence connecté à ladite seconde entrée (30) du comparateur; des moyens formant circuit de charge supplémentaire (14 à 17) connectés en parallèle sur ledit réseau de condensateurs pour régler la charge stockée dans ledit réseau de condensateurs; des moyens de commande d'erreur (22) pour commander le réglage de la charge stockée dans ledit réseau de condensateurs et des moyens formant registre (20) pour conserver le réglage de charge de chaque condensateur desdits plusieurs condensateurs dudit réseau de condensateurs.

3. Convertisseur analogique-numérique selon la revendication 2, caractérisé en outre en ce que lesdits moyens formant circuit de charge supplémentaire comprennent des condensateurs de circuit de charge et des moyens formant commutateur pour mettre les condensateurs de circuit de charge en parallèle sur lesdits plusieurs condensateurs de réseau de condensateurs.

4. Convertisseur analogique-numérique selon la revendication 1 ou 2, caractérisé en outre par des moyens équivalents à des condensateurs de bits de plus faible poids pour jouer le rôle des condensateurs les plus faibles parmi lesdits plusieurs condensateurs dudit réseau de condensateurs, lesdits moyens équivalent à des condensateurs de bits de plus faible poids comprenant: un réseau (26) de résistances connectées en série; une seconde série de condensateurs (14 à 17) qui sont pondérés en binaire et connectés en réseau; et le réseau de résistances connectées en série et la seconde série de condensateurs étant également connectés en parallèle avec lesdits plusieurs condensateurs dudit réseau de condensateurs mentionné en premier.

5. Convertisseur analogique-numérique selon la revendication 4, caractérisé en outre en ce que ledit réseau de résistances détermine les six bits de plus faible poids dudit signal d'entrée analogique.

6. Convertisseur analogique-numérique selon l'une quelconque des revendications précédentes, caractérisé en outre en ce que ledit réseau de condensateurs comporte huit condensateurs pondérés en binaire pour mesurer les huit bits les plus significatifs du signal d'entrée analogique.

7. Convertisseur analogique-numérique selon l'une quelconque des revendications précédentes, caractérisé en outre en ce que lesdits moyens formant comparateur (4) comprennent plusieurs amplificateurs différentiels (230, 219, 220, 221) connectés en cascade, chacun comprenant une paire de bornes d'entrée différentielle (29, 30 pour 230) et une paire de bornes de sortie différentielle (209, 210 pour 230), les bornes d'entrée du premier desdits plusieurs amplificateurs différentiels étant lesdites première et seconde entrées du comparateur, les bornes de sortie différentielle de chaque amplificateur différentiel étant connectées aux bornes d'entrée différentielle de l'amplificateur différentiel suivant en cascade; des moyens formant amplificateur de puissance (au-dessous de la ligne 247) connectés aux bornes de sortie différentielle du dernier amplificateur (22); en cascade pour amplifier de manière séparée les signaux auxdites bornes de sortie différentielle dudit dernier amplificateur différentiel en cascade; et plusieurs moyens d'isolation de réinitialisation (215, 216, 217, 218), ayant chacun une borne d'entrée de réinitialisation et une borne de sortie de réinitialisation, chaque borne de sortie de réinitialisation étant connectée à l'un correspondant desdits plusieurs amplificateurs différentiels pour bloquer la tension aux bornes de sortie différentielle dudit amplificateur différentiel correspondant, à la réception d'un signal sur ladite borne d'entrée de réinitialisation, lesdits plusieurs moyens d'isolation de réinitialisation étant connectés en cascade, la borne d'entrée de réinitialisation de chacun des moyens d'isolation de réinitialisation étant connectée à la borne de sortie de réinitialisation des moyens d'isolation de réinitialisation correspondant à l'amplificateur différentiel précédent pour fournir une réinitialisation temporisée séquentiellement aux amplificateurs différentiels successifs.

EP  0 078 608  B1

Fig.1

1

52 POWER

53 VRH

54 VIN

55 VRL

56

SIGNAL
GROUND

51

62

57 58 B PORT C PORT 59

V$_{SS}$
GND

*Fig. 2*

60 61

B PORT C PORT 63

77 76

75

83

80

85

84

86

87

88

89

90

82

81

78

97

91

92

93

94

95

96

98

79

*Fig. 3*

103 SµC A/D 101

102

99 100

MLP

*Fig. 4*

Fig. 5

Fig.6

Fig.7

Fig.8

Fig. 9

Fig.10

Fig.11

8

Fig.12

EP 0 078 608 B1

Fig.13

Fig.14a

Fig.14b

Fig.15

*Fig.16*

Fig.17a

TO FIG.17b

FROM FIG.17a

Fig.17b